# EUROPEAN PATENT APPLICATION

(11) **EP 1 981 159 A1**
(43) Date of publication of application: **15.10.2008**
(21) Application number: 06822994.7
(22) Date of filing: 06.11.2006
(51) Int. Cl.: H02M 7/48

(54) **REFRIGERATION CYCLE DEVICE**

(30) Priority: 31.01.2006 JP 2006023904
(71) Applicant: Toshiba Carrier Corporation, Tokyo 105-8001 (JP)
(72) Inventor: TOSHI, Tomoaki, c/o Fuji Operation Center, Shizuoka-ken 416-8521 (JP); SHIMIZU, Shinya, c/o Fuji Operation Center, Shizuoka-ken 416-8521 (JP); ENDO, Takahisa, c/o Fuji Operation Center, Shizuoka-ken 416-8521 (JP); ISHIDA, Keiichi, c/o Fuji Operation Center, Shizuoka-ken 416-8521 (JP)
(74) Representative: HOFFMANN EITLE
(86) International application number: PCT/JP2006/322080
(87) International publication number: WO 2007/088660

(57) **Abstract**

MOSFETs (4u, 4v, and 4w) and IGBTs (3u, 3v, and 3w) are arranged linearly along an end edge of a printed circuit board (50) in a state where the MOSFETs (4u, 4v, and 4w) and the IGBTs (3u, 3v, and 3w) are close to each other. Further, one heatsink (54) is attached to the MOSFETs (4u, 4v, and 4w) and the IGBTs (3u, 3v, and 3w).

## Description

### Technical Field

The present invention relates to a refrigerating cycle apparatus in which a compressor is driven by an inverter apparatus.

### Background Art

An inverter apparatus for driving a brushless DC motor used for a compressor of a refrigerating cycle apparatus such as an air conditioner and a refrigerator is provided with a plurality of series circuits of two switching elements which are arranged on the upstream and downstream sides in the voltage application direction, and an interconnection between the upstream side switching element and the downstream side switching element of each series circuit is connected to each phase winding of the brushless DC motor. Each switching element is provided with a reflux diode (also called a parasitic diode).

In general, an IGBT or a MOSFET is often employed as a switching element recently. When a MOSFET is used, the on-off speed of the MOSFET is high, and hence the merit that high-frequency switching is enabled is obtained. Further, the loss at the time of a low-voltage output is small, and hence the MOSFET is often used to drive a motor of a small output such as a fan motor or the like.

However, the MOSFET has a problem that the reverse recovery characteristic of a reflux diode formed on the same element in the process of the element manufacture is poor. In recent years, a super-junction MOSFET which is low in the on-time resistance, and is excellent in the switching characteristic has been developed. However, in this super-junction MOSFET, the reverse recovery characteristic of the reflux diode formed on the element is still poorer.

If the reverse recovery characteristic is poor, the following problem is caused. That is, when the MOSFET is turned off, a forward current (also called a reflux current) flows through the reflux diode of the MOSFET due to the energy stored in the inductive load. In this state, if the other switching element of the same series circuit is turned on, and a DC voltage is applied to the MOSFET, a large reverse recovery current (also called a spike current) resulting from an electric charge stored in the reflux diode flows through the reflux diode. This reverse recovery current is a large power loss. Further, most of this power loss becomes the heat generated when the other switching element which is paired with the MOSFET is turned on. If this heat becomes large, a problem is caused that the other switching element is destroyed by the heat.

Because of such circumstances, it is very difficult to employ a MOSFET in an inverter through which a large current for driving a compressor flows.

Thus, there is heretofore a configuration in which a reverse voltage application circuit for applying a reverse voltage to the reflux diode of the MOSFET prior to turning-on of the other switching element is provided, and a reverse recovery current is prevented from flowing through the reflux diode by the application of the reverse voltage, thereby reducing the power loss (for example, Jpn. Pat. Appln, KOKAI Publication No. 10-327585). By virtue of this configuration, it becomes possible to employ the MOSFET as the switching element in a large-output motor for compressor motor drive or the like.

Although it is also possible to use MOSFETS for all the elements in an inverter apparatus. However, in consideration of the degree of improvement in the efficiency, and a cost of addition of a reverse voltage application circuit, a scheme in which an IGBT or the like is used as the upstream side switching element as before, and a MOSFET is used only as the downstream side switching element is conceivable.

### Disclosure of Invention

In an inverter apparatus, how to arrange switching elements on a printed circuit board, or how to deal with generation of heat of the switching elements is an important factor in planning to reduce the apparatus size or to stabilize the operation of the apparatus.

An object of the refrigerating cycle apparatus of the present invention is to make it possible to arrange switching elements including MOSFETs on a printed circuit board with high space efficiency and with high radiation efficiency, thereby to reduce the size of an inverter apparatus and stabilize an operation of the inverter apparatus.

A refrigerating cycle apparatus of the present invention comprises a compressor, a condenser, and an evaporator, in which the compressor is driven by an inverter apparatus, wherein
the inverter apparatus includes a switching circuit, and
the switching circuit includes a plurality of series circuits, in each of which an IGBT and a MOSFET provided with a reflux diode are connected to each other in series so as to maintain an upstream side/downstream side relationship,
a plurality of reverse voltage application circuits, each of which applies a reverse voltage, prior to being turned on of an IGBT of each of the series circuits, to a reflux diode of a MOSFET in the same series circuit as the IGBT,
a printed circuit board on which the reverse voltage application circuits are mounted, the IGBTs are mounted in a state where the IGBTs are adjacent to each other, and the MOSFETs are mounted in a state where the MOSFETs are adjacent to each other, and
a heat radiation member to which the IGBTs and the MOSFETs are attached.

### Brief Description of Drawings

FIG. 1 is a block diagram showing a configuration of an embodiment and a configuration of a refrigerating cycle.
FIG. 2 is a view showing an arrangement state of IGBTs and MOSFETs on a printed circuit board in the embodiment.
FIG. 3 is a view showing an arrangement of each part and a wiring pattern on the printed circuit board in the embodiment.

### Best Mode for Carrying Out the Invention

[1] An embodiment of the present invention will be described below with reference to the accompanying drawings.

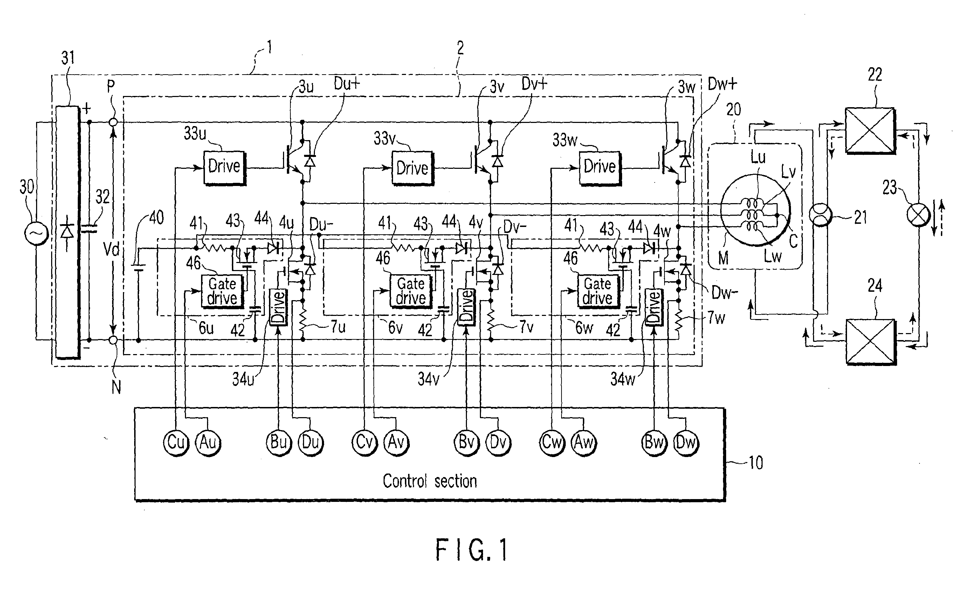

In FIG. 1, a reference symbol M denotes a brushless DC motor (load) used as a compressor motor of an air conditioner which is a kind of refrigerating cycle apparatus, and the brushless DC motor is constituted of a stator including star-connected three phase windings Lu, Lv, and Lw, and a rotor including a permanent magnet. The rotor is rotated by an interaction between a magnetic field formed by the currents flowing through the phase windings Lu, Lv, and Lw and a magnetic field formed by the permanent magnet.

This brushless DC motor M is contained in a compressor 20 as a power source of a compression mechanism. At the time of cooling, a refrigerant discharged from the compressor 20 flows into an outdoor heat exchanger 22 through a four-way valve 21 as shown by a solid line arrow, and the refrigerant that has passed the outdoor heat exchanger 22 flows into an indoor heat exchanger 24 through an expansion valve 23. Further, the refrigerant that has passed the indoor heat exchanger 24 is sucked into the compressor 20 through the four-way valve 21. As a result of this, the outdoor heat exchanger 22 functions as a condenser, and the indoor heat exchanger 24 functions as an evaporator. At the time of heating, the four-way valve 21 is switched, whereby the refrigerant flows in the direction shown by a broken line arrow, and the indoor heat exchanger 24 functions as a condenser, and the outdoor heat exchanger 22 functions as an evaporator.

An inverter apparatus 1 is connected to the brushless DC motor M. This inverter apparatus 1 is constituted of a rectifying element 31 for rectifying a voltage of a commercial alternating-current source 30, a smoothing capacitor 32 connected to output terminals of the rectifying element 31, DC terminals P and N connected to both ends of the smoothing capacitor 32, a switching circuit 2 for receiving a DC voltage (for example, 280V DC) between the terminals P and N, and causing a current to the phase windings Lu, Lv, and Lw, a control section 10 for driving/controlling the switching circuit 2, and the like.

This switching circuit 2 includes a series circuit in which two switching elements are connected in series so as to maintain an upstream side/downstream side relationship in the application direction of the DC voltage for each of the three phases of U, V, and W. As the switching element on the upstream side of each series circuit, an element other than a MOSFET, for example, an insulated gate bipolar transistor (IGBT) is used, and a low-power-loss MOSFET (super-junction MOSFET or the like) is used as the downstream side switching element. That is, the series circuit of the phase U includes an IGBT 3u on the upstream side, and a MOSFET 4u on the downstream side. The series circuit of the phase V includes an IGBT 3v on the upstream side, and a MOSFET 4v on the downstream side. The series circuit of the phase W includes an IGBT 3w on the upstream side, and a MOSFET 4w on the downstream side.

Each of reflux diodes Du+, Dv+, and Dw+ is connected in inversely parallel with each of the IGBTs 3u, 3v, and 3w. Each of reflux diodes Du-, Dv-, and Dw- is connected in inversely parallel with each of the MOSFETs 4u, 4v, and 4w. These reflux diodes are embedded in the element main bodies of the corresponding MOSFETs as parasitic diodes.

Drive circuits 34u, 34v, and 34w are provided to drive the MOSFETs 4u, 4v, and 4w. These drive circuits 34u, 34v, and 34w on/off-drive the MOSFETs 4u, 4v, and 4w in accordance with instructions from output terminals Bu, Bv, and Bw of the control section 10. Likewise, drive circuits 33u, 33v, and 33w on/off-drive the IGBTs 3u, 3v, and 3w.

An unconnected end of each of the phase windings Lu, Lv, and Lw is connected to each of an interconnection point between the IGBT 3u and the MOSFET 4u, an interconnection point between the IGBT 3v and the MOSFET 4v, and an interconnection point between the IGBT 3w and the MOSFET 4w.

Further, the switching circuit 1 includes reverse voltage application circuits 6u, 6v, and 6w for applying a reverse voltage to the reflux diodes Du-, Dv-, and Dw- of the MOSFETs 4u, 4v, and 4w prior to being turned on of the IGBTs 3u, 3v, and 3w in order to suppress a reverse recovery current Irr which flows through each of the reflux diodes Du-, Dv-, and Dw-concomitantly with being turned on of the IGBTs 3u, 3v, and 3w on the upstream side when a forward current (reflux current) flows through each of the reflux diodes Du-, Dv-, and Dw- due to energy stored in the phase windings Lu, Lv, and Lw which are inductive loads.

The reverse voltage application circuit 6u applies an output voltage (for example, 15V) of a low-voltage DC power source circuit 40 to a reverse voltage application capacitor 42 through a resistor 41, and applies a voltage of the reverse voltage application capacitor 42 to the reflux diode Du- of the MOSFET 4u as a reverse voltage through a drain-source part of a reverse voltage application MOSFET 43, and a diode 44. Further, the reverse voltage application circuit 6u includes a gate drive circuit 46 as a circuit for driving the reverse voltage application MOSFET 43. The gate drive circuit 46 generates and outputs a pulse signal for reverse voltage application in accordance with an instruction from an output terminal Au, Av, or Aw of the control section 10. This output is supplied to a gate of the reverse voltage application MOSFET 43.

The configurations of the other reverse voltage application circuits 6v and 6w are identical with that of the reverse voltage application circuit 6u. Hence, a description of the other reverse voltage application circuits 6v and 6w will be omitted.

Further, a resistor 7u for current detection is inserted and arranged in a downstream part of the MOSFET 4u in the series circuit of the IGBT 3u and the MOSFET 4u. A resistor 7v for current detection is inserted and arranged in a downstream part of the MOSFET 4v in the series circuit of the IGBT 3v and the MOSFET 4v. A resistor 7w for current detection is inserted and arranged in a downstream part of the MOSFET 4w in the series circuit of the IGBT 3w and the MOSFET 4w. A voltage of a level corresponding to a current which flows through the MOSFET 4u, 4v, or 4w is generated at the resistor 7u, 7v, or 7w. The voltages generated at the resistors 7u, 7v, and 7w are supplied to the control section 10.

The control section 10 detects a current which flows through each of the phase windings of the brushless DC motor M from each of the voltages generated at the resistors 7u, 7v, and 7w, detects a rotational speed of the rotor and a rotor position of the brushless DC motor M from the detected currents, and drives each of the IGBTs, each of the MOSFETs, and each of the reverse voltage application circuits of the switching circuit 1 at predetermined timings based on the detected rotation. Further, the control section 10 includes, as a principal function, a control means for successively switching energization of each phase winding established by an upstream side IGBT of at least one of the series circuits in the switching circuit 1, and a downstream side MOSFET of at least another of the series circuits.

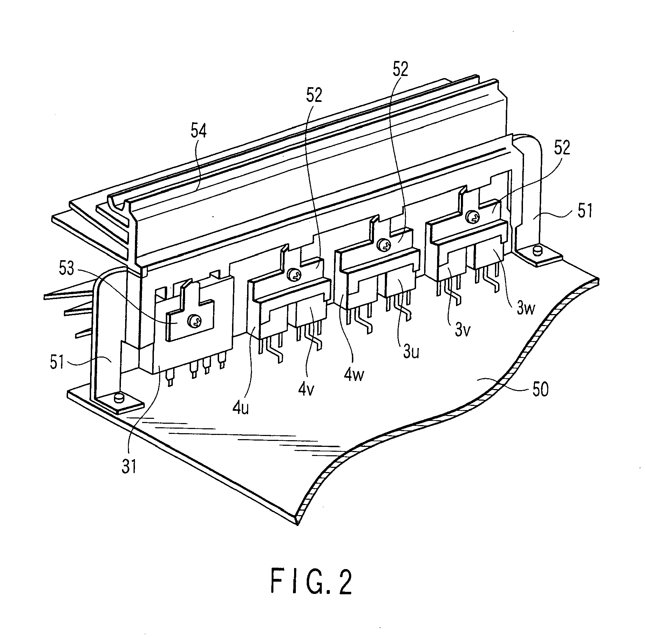

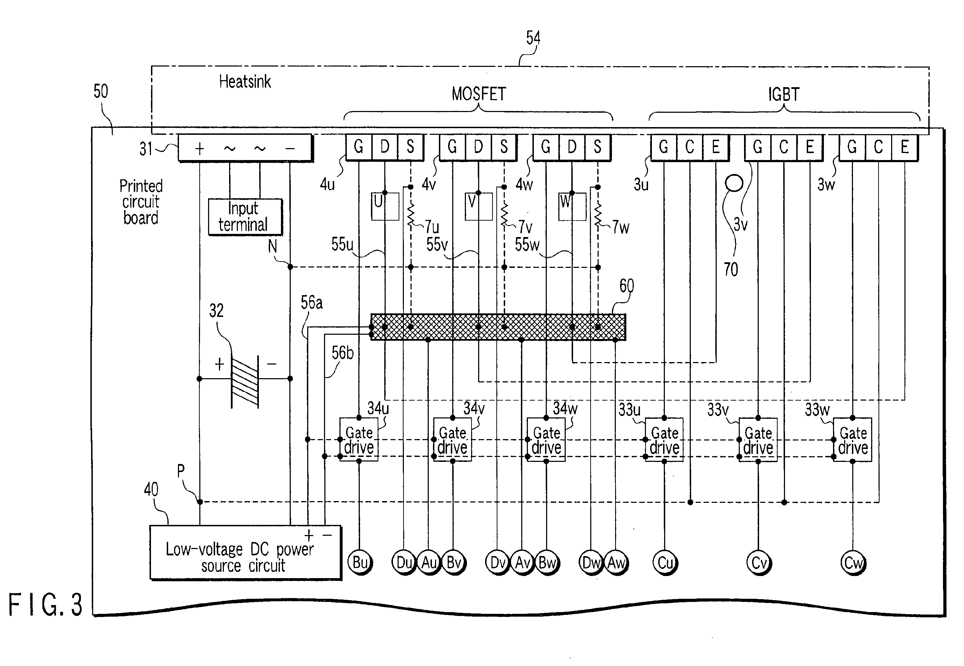

The arrangement and attachment structure of each IGBT and each MOSFET of the circuit configured as described above will be described below with reference to FIGS. 2 and 3. As shown in FIG. 2, a frame 51 formed of a metal plate is made to rise at an end part of a printed circuit board 50, and the frame 51 is provided with three holding members 52 and one holding member 53. Of these holding members, on the three holding members 52, the MOSFETs 4u, 4v, and 4w, and the IGBTs 3u, 3v, and 3w are grouped and held in such a manner that two of them are held on each holding member, linearly along the end edge of the printed circuit board 50, and close to each other. That is, the MOSFETs 4u, 4v, and 4w are arranged so as to be adjacent to each other as the MOSFET group, and the IGBTs 3u, 3v, and 3w are arranged so as to be adjacent to each other as the IGBT group. Further, terminal pins of each of the MOSFETs 4u, 4v, and 4w, and the IGBTs 3u, 3v, and 3w are connected to the wiring pattern (not shown) on the printed circuit board 50 by sldering.

The rectifying element 31 is held on the holding member 53, and the wiring of the rectifying element 31 is connected to the wiring pattern (not shown) on the printed circuit board 50 by soldering. This rectifying element 31 is also arranged linearly along the end edge of the printed circuit board 50 so as to be aligned with the group of the MOSFETs 4u, 4v, and 4w, and the group of the IGBT 3u, 3v, and 3w.

Further, a heat radiation member, for example, a heatsink (radiator plate with fins) 54 made of aluminum having good heat conductivity is attached to the rear surfaces of the MOSFETs 4u, 4v, and 4w, the IGBTs 3u, 3v, and 3w, and the rectifying element 31. This heatsink 54 is held by the frame 54, and is in close contact with the rear surfaces of the MOSFETs 4u, 4v, and 4w, the IGBTs 3u, 3v, and 3w, and the rectifying element 31.

The rectifying element 31, the MOSFETs 4u, 4v, and 4w, and the IGBTs 3u, 3v, and 3w are arranged linearly along the end edge of the printed circuit board 50, and hence it is possible to cause one heatsink 54 to be in close contact with all of the rectifying element 31, the MOSFETs 4u, 4v, and 4w, and the IGBTs 3u, 3v, and 3w easily, and moreover, in a space-saving manner. Accordingly, it is possible to efficiently radiate the heat generated from the rectifying element 31, the MOSFETs 4u, 4v, and 4w, and the IGBTs 3u, 3v, and 3w by only one heatsink 54. By virtue of the improvement in the heat radiation efficiency, it is possible to stabilize the operation of the inverter apparatus 1.

Moreover, in the configuration, the switching elements are grouped into the group of the MOSFETs 4u, 4v, and 4w, and the group of the IGBTs 3u, 3v, and 3w so as to be arranged side by side, and hence it is possible to arrange the MOSFETs 4u, 4v, and 4w and the IGBTs 3u, 3v, and 3w on the printed circuit board with high space efficiency. As a result of this, it is possible to effectively make use of the space on the printed circuit board 50 so as to attach other components thereto, and make the size of the inverter apparatus 1 small.

That is, as shown in FIG. 3, a hybrid IC 60 formed by integrating the reverse voltage application circuits 6u, 6v, and 6w into one body is mounted on the printed circuit board 50 in the vicinity of the MOSFETs 4u, 4v, and 4w, and in a state where the IC 60 is opposed to the line of the MOSFETs 4u, 4v, and 4w. Further, linear wiring patterns 55u, 55v, and 55w are provided on the top surface of the printed circuit board 50 between the MOSFETs 4u, 4v, and 4w and the hybrid IC 60. Current pathways between the MOSFETs 4u, 4v, and 4w and the reverse voltage application circuits 6u, 6v, and 6w are formed by the wiring patterns 55u, 55v, and 55w.

The MOSFETs 4u, 4v, and 4w and the reverse voltage application circuits 6u, 6v, and 6w are close to each other, and the wiring patterns 55u, 55v, and 55w between them are linear, and hence the current pathways between the MOSFETs 4u, 4v, and 4w and the reverse voltage application circuits 6u, 6v, and 6w are shorten to the utmost. As a result of this, external noise is hardly superposed on a voltage to be applied from each of the reverse voltage application circuits 6u, 6v, and 6w to each of the MOSFETs 4u, 4v, and 4w. By the improvement in the noise immunity, it is possible to stabilize the operation, and improve the reliability.

Besides, the smoothing capacitor 32, the drive circuits 33u, 33v, 33w, 34u, 34v, and 34w, the low-voltage DC power source circuit 40, and a temperature sensor 70, and the like are mounted on the printed circuit board 50, and these are connected to each other by wiring patterns. The solid lines indicate wiring patterns on the top surface side of the printed circuit board 50, and the broken lines indicate wiring patterns on the undersurface side of the printed circuit board 50.

In general, in order to shorten the wiring pattern, the low-voltage DC power source circuit 40 is mounted on the printed circuit board 50 on the rectifying element 31 side. This low-voltage DC power source circuit 40 produces the operation voltage (DC low voltage) of the reverse voltage application circuits 6u, 6v, and 6w from the output of the rectifying element 31, and is mounted on the printed circuit board 50 on the rectification element 31 side. Further, wiring patterns 56a and 56b for supplying the operation voltage are provided on the printed circuit board 50 between the low-voltage DC power source circuit 40 and the hybrid IC (reverse voltage application circuits 6u, 6v, and 6w) 60. The low-voltage DC power source circuit 40 is mounted on the printed circuit board 50 on the rectifying element 31 side, the group of the MOSFETs 4u, 4v, and 4w is arranged at a position adjacent to the rectifying element 31, and the hybrid IC (reverse voltage application circuits 6u, 6v, and 6w) 60 is mounted at a position opposed to the MOSFETs 4u, 4v, and 4w, and hence it is consequently possible to make the wiring patterns 56a and 56b short.

The temperature sensor 70 is provided in the vicinity of the IGBTs 3u, 3v, and 3w, and is used to appropriately detect a large temperature rise of the IGBTs 3u, 3v, and 3w as an abnormality (a failure or a malfunction) of the reverse voltage application circuits 6u, 6v, and 6w.

Incidentally, in the embodiment described above, the group of the MOSFETs 4u, 4v, and 4w is arranged adjacent to the rectifying element 31, and the group of the IGBTs 3u, 3v, and 3w is arranged adjacent to the group of the MOSFETs 4u, 4v, and 4w. However, a configuration in which the group of the IGBTs 3u, 3v, and 3w is arranged adjacent to the rectifying element 31, and the group of the MOSFETs 4u, 4v, and 4w is arranged adjacent to the group of the IGBTs 3u, 3v, and 3w is also allowable although the wiring for supplying the power source to the reverse voltage application circuits 6u, 6v, and 6w is made slightly complicated.

### Industrial Applicability

The refrigerating cycle apparatus of the present invention can be utilized when a compressor of an air conditioner or a refrigerator is driven by an inverter apparatus.

## Claims

1. A refrigerating cycle apparatus comprising a compressor, a condenser, and an evaporator, in which the compressor is driven by an inverter apparatus, wherein
the inverter apparatus includes a switching circuit, and
the switching circuit includes a plurality of series circuits, in each of which an IGBT and a MOSFET provided with a reflux diode are connected to each other in series so as to maintain an upstream side/downstream side relationship,
a plurality of reverse voltage application circuits, each of which applies a reverse voltage, prior to being turned on of an IGBT of each of the series circuits, to a reflux diode of a MOSFET in the same series circuit as the IGBT,
a printed circuit board on which the reverse voltage application circuits are mounted, the IGBTs are mounted in a state where the IGBTs are adjacent to each other, and the MOSFETs are mounted in a state where the MOSFETs are adjacent to each other, and
a heat radiation member to which the IGBTs and the MOSFETs are attached.

2. The refrigerating cycle apparatus according to claim 1, wherein
the reverse voltage application circuits are mounted on the printed circuit board in the vicinity of the MOSFETs.

3. The refrigerating cycle apparatus according to claim 2, further comprising linear wiring patterns provided on the printed circuit board between the MOSFETs and the reverse voltage application circuits.

4. The refrigerating cycle apparatus according to claim 1, wherein
the inverter apparatus includes a rectifying element for rectifying a voltage of an alternating-current source, and inputs an output of the rectifying element to the switching circuit, and
the rectifying element together with the MOSFETs and the IGBTs are mounted on the printed circuit board so as to be arranged linearly in the order of the rectifying element, the MOSFETs, and the IGBTs, and the rectifying element, the MOSFETs, and the IGBTs are attached to the heat radiation member.

5. The refrigerating cycle apparatus according to claim 4, further comprising:
a low-voltage DC power source circuit which produces an operation voltage of the reverse voltage application circuits from an output of the rectifying element, and is mounted on the printed circuit board on the rectifying element side; and
wiring patterns for supplying the operation voltage which are provided on the printed circuit board between the low-voltage DC power source circuit and the reverse voltage application circuits.
